# EUROPÄISCHE PATENTSCHRIFT

(11) **EP 1 234 337 B1**
(45) Veröffentlichungstag und Bekanntmachung des Hinweises auf die Patenterteilung: **12.08.2009**
(21) Anmeldenummer: 00993290.6
(22) Anmeldetag: 30.11.2000
(51) Int. Cl.: H01L 29/78, H01L 27/07, H01L 29/10, H01L 27/02

(54) **HALBLEITERSCHALTUNGSANORDNUNG UND VERFAHREN ZUR HERSTELLUNG**
SEMICONDUCTOR CIRCUIT ARRANGEMENT AND A METHOD FOR PRODUCING SAME
CIRCUIT A SEMI-CONDUCTEURS ET SON PROCEDE DE PRODUCTION

(30) Priorität: 30.11.1999 DE 19957533
(43) Veröffentlichungstag der Anmeldung: 28.08.2002
(73) Patentinhaber: Infineon Technologies AG, 81669 München (DE)
(72) Erfinder: HERZUM, Christian, 82343 Pöcking (DE); MÜLLER, Karl-Heinz, 84149 Velden (DE); KRUMBEIN, Ulrich, 83026 Rosenheim (DE)
(74) Vertreter: Zimmermann & Partner
(86) Internationale Anmeldenummer: PCT/EP2000/012050
(87) Internationale Veröffentlichungsnummer: WO 2001/041194

(56) Entgegenhaltungen:
- EP-A- 0 551 940
- EP-A- 1 011 137
- DE-A- 19 860 505
- US-A- 5 620 920
- US-A- 5 937 298
- PATENT ABSTRACTS OF JAPAN vol. 1998, no. 10, 31. August 1998 (1998-08-31) -& JP 10 125913 A (SONY CORP), 15. Mai 1998 (1998-05-15)
- PATENT ABSTRACTS OF JAPAN vol. 007, no. 162 (E-187), 15. Juli 1983 (1983-07-15) -& JP 58 070572 A (HITACHI SEISAKUSHO KK), 27. April 1983 (1983-04-27)
- PATENT ABSTRACTS OF JAPAN vol. 017, no. 353 (E-1393), 5. Juli 1993 (1993-07-05) -& JP 05 055251 A (NEC CORP), 5. März 1993 (1993-03-05)

## Beschreibung

Die Erfindung betrifft eine Halbleiterschaltungsanordnung nach Anspruch 9 , sowie ein Verfahren zur Herstellung einer Halbleiterschaltungsanordnung nach Anspruch 1

EP 0 551 940 A2 offenbart ein Verfahren zur Herstellung einer Halbleiterschaltungsanordnung mit zwei benachbart angeordneten Steueranschlüssen wobei die Steueranschlüsse aus einer silizurten polykristallinen Siliziumschicht strukturiert werden.

Als Beispiel für solche Halbleiterschaltungsanordnungen sind auch MOS-Tetroden und MOS-Pentoden mit mehreren Steueranschlüssen, insbesondere mit mindestens zwei Gate-Anschlüssen, nämlich einem Hochfrequenzgate und mindestens einem Regelgate bekannt, die entweder als Einzelbauelemente oder in hochintegrierter Form auf einem Halbleitersubstrat vermittels VLSI-Technolgieschritten gefertigt werden (VLSI = very large scale integration). Insbesondere bei einem Einsatz solcher MOS-Tetroden im Automobilbereich wird eine Eignung für Versorgungsspannungen von 12 V oder mehr gefordert. Die modernen CMOS-Prozessfertigungsverfahren sind in der Regel nur für die Fertigung von Halbleiterschaltungen für Versorgungsspannungen ≤ 5 V ausgelegt und eignen sich nicht ohne Weiteres zur Fertigung von Halbleiterschaltungen mit höheren Versorgungsspannungsbereichen. Wesentliche technologische Gründe hierfür liegen unter anderem in der zu geringen Gateoxiddikke, sowie in einer zu niedrigen Drain-Wannen-Durchbruchspannung bei den in modernen Standard-CMOS-Prozessen gefertigten Halbleiterschaltungen, die sich daher nicht ohne Weiteres zur Fertigung von MOS-Tetroden und MOS-Pentoden mit Versorgungsspannungen von 12 V oder mehr eignen.

Wichtig ist weiterhin das Hochfrequenzverhalten solcher MOS-Tetroden und MOS-Pentoden, wobei vor allem der elektrische Widerstand der Gateanschlüsse, und insbesondere des Hochfrequenzgates problematisch ist, da das Widerstandsrauschen im

Hochfrequenz-Gate in der Tetrode verstärkt wird und damit die Rauschgüte des Bauelementes bestimmt wird. Außerdem sinkt mit zunehmendem Gate-Widerstand die erreichbare Hochfrequenzverstärkung. Zur Erzielung eines möglichst geringen Gate-Widerstandes werden bei den für MOS-Tetroden verwendeten Prozessen durchweg Metall-Gates verwendet, deren Schichtwiderstand mit einem typischen Wert von etwa Rₛ = 40 mΩ/□ um Größenordnungen niedriger ist als bei den in CMOS-Prozessen üblicherweise verwendeten Polygates mit typischen Schichtwiderständen um R*ₛ*. = 20 bis 150 Ω/□.

Der Erfindung liegt die Aufgabe zugrunde, eine Halbleiterschaltungsanordnung mit mehreren Steueranschlüssen, namentlich mindestens zwei Gateanschlüssen, von denen einer ein Hochfrequenzgate ist, wie bei Tetroden oder Pentoden zur Verfügung zu stellen, die einen Gate-widerstand der Steueranschlüsse in vergleichbar geringer Grö-Benordnung wie bei Metall-Gates üblicherweise erreicht besitzen, sowie ein einfach durchzuführendes Verfahren zur Herstellung einer solchen Halbleiterschaltungsanordnung anzugeben.

Die Lösung der Aufgabe erfolgt durch das in Anspruch 1 angegebene Verfahren und die im Anspruch gangegebene Halbleiterschaltungsanordnung.

Gemäß der Erfindung ist vorgesehen, dass der eine Steueranachluss der wenigstens zwei Steueranschlüsse nicht oder nur teilweise siliziert wird. Durch den verbleibenden, silizierten Teil des Steueranschlusses wird der Steueranschluss insgesamt hinreichend niederohmig. Der nicht silizierte Teil des Steueranschlusses kann hierbei eine Ausdehnung von etwa 0,2 µm bis etwa 0,8 µm, insbesondere 0,4 µm bei einer Mindestlänge des Steueranschlusses von etwa 0,6 µm bis etwa 3,0 µm, insbesondere 1,4 µm besitzen.

Somit ist vorgesehen, dass der eine, vorzugsweise aus Polysilizium gefertigte Steueranschluss auf seiner der Hauptoberfläche des Halbleitersubstrates abgewandten Seite nur bereichsweise siliziert wird. Zur Verringerung des Schichtwiderstandes schlägt die Erfindung sonach vor, den anderen Steueranschluss aus Polysilizium zu silizieren, wodurch ein im Vergleich zur bisherigen Metall-Gate-Technologie vergleichbarer Rauschwert erzielt werden kann. Versuche haben gezeigt, dass das Rauschen wesentlich schlechter ist, falls die Steueranschlüsse bzw. Gates aus Polysilizium nicht siliziert werden. Bei Verwendung von TiSi für die Silizierung können Schichtwiderstände Rₛ von etwa 3 Ω/□ erzielt werden.

In Weiterführung der Erfindung kann vorgesehen sein, dass der erste Elektrodenanschluss bzw. Drainanschluss von der Silizierung ausgespart wird. Grundsätzlich werden mit dem selbstjustierenden Silizid-Prozeas nach der Erfindung die Gate-, Source-, Zwischen- und Draingebiete gleichzeitig siliziert. Es hat sich jedoch herausgestellt, dass silizierte Drainanschlüsse eine ungünstiger Festigkeit gegenüber elektrostatischen Entladungen (ESD-Festigkeit; ESD = electrostatic discharge) besitzen. Insbesondere in solchen Anwendungen, bei denen die erfindungsgemäße Halbleiterschaltungsanordnung, insbesondere Tetrode oder Pentode als diskretes Bauelement, oder als sogenannter I/O-Transistor in einer integrierten Schaltung zum Einsatz gelangt, und hierbei zu befürchten ist, dass silizierte Drains zu einer unzureichenden ESD-Festigkeit führen, sollten die Draingebiete von der Silizierung ausgespart sein.

Weiterhin kann möglich sein, dass das Regelgate überhaupt nicht siliziert wird, und das Zwischengebiet zwischen den dem Drainanschluss nächstgelegenen Gate und dem hieran unmittelbar benachbarten Gate teilsiliziert wird.

Andererseits kann ebenso eine ausreichende ESD-Festigkeit erreicht werden, wenn man den ersten Elektrodenanschluss bzw. Drainanschluss nur teilweise siliziert und der Abstand zwischen dem silizierten Bereich des Elektrodenanschlusses (Drainanschlusses) und den zugehörenden Kontakten ausreichend groß wählt.

Bevorzugte Weiterbildungen der Erfindung ergeben sich aus den weiteren Unteransprüchen.

Weitere Merkmale, Vorteile und Zweckmäßigkeiten der Erfindung ergeben sich aus der nachfolgenden Beschreibung von Ausführungsbeispielen der Erfindung anhand der Zeichnung. Es zeigen:
- Figur 1: eine schematische Schnittansicht eines bevorzugten Ausführungsbeispieles der Erfindung;
- Figur 2: eine schematische Schnittansicht eines Ausführungsbeispieles der Erfindung, bei dem das zweite Gate teil-siliziert ist;
- Figur 3: eine schematische Schnittansicht eines Ausführungsbeispieles der Erfindung, bei dem das zweite Gate vollständig von der Silizierung ausgenommen ist; und
- Figur 4: eine schematische Schnittansicht eines erlänternden Ausführungsbeispieles, bei dem das Draingebiet teil-siliziert ist.

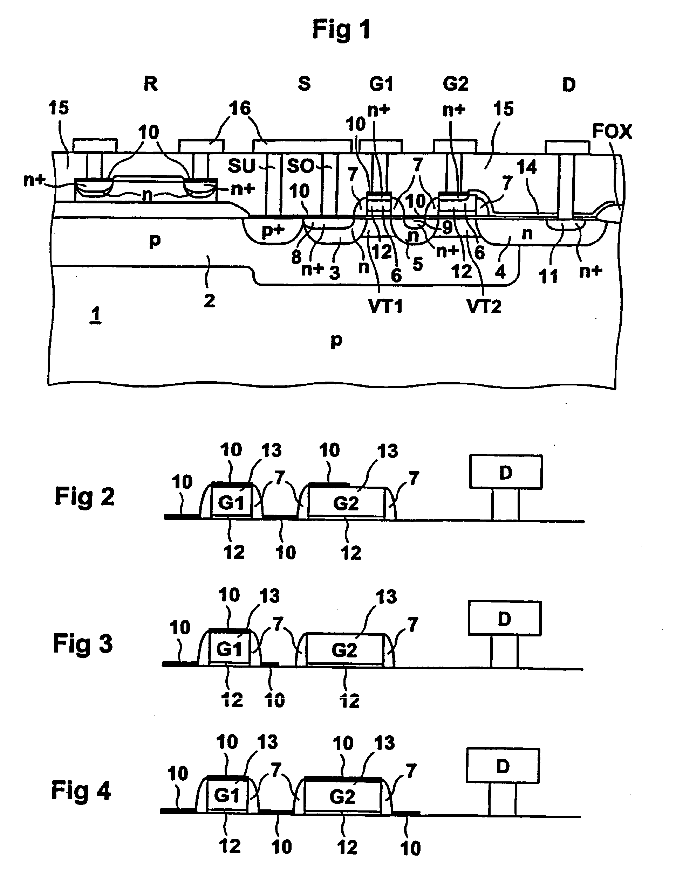

Die in Figur 1 gezeigte Halbleiterachaltungsanordnung umfaßt eine Hochfrequenz-MOS-Tetrode als Schaltungselement einer integrierten Halbleiterschaltung nach dem besonders bevorzugten Ausführungsbeispiel der Erfindung. Sie ist nach einem Standard-CMOS-Prozessverfahren hergestellt, das als bekannt vorausgesetzt wird mit einem Halbleitersubstrat 1 aus p-leitendem Silizium (p-Dotierung = erster Leitfähigkeitstyp nach dieser Definition), wobei das integriert ausgebildete Schaltungselement wenigstens zwei Steueranschlüsse aus Polysilizium 6 auf Gate-Dielektrika 12, nämlich ein Hochfrequenzgate G1 mit einem Kanalbereich VT1 und ein durch das Zwischengebiet getrenntes Regelgate G2 mit einem Kanalbereich VT2, sowie einen ersten Elektrodenanschluss, nämlich einen Drainanschluss D, und einen zweiten Elektrodenanschluss, nämlich Sourceanschluss S (bestehend aus Source So und Substratanschluss Su) aufweist. Die unter den Polygates G1 und G2 angeordneten Kanalbereiche VT1 und VT2 können durch unterschiedliche Kanalimplantationen unterschiedlich dotiert sein, also auch etwa jeweils n- oder p-dotiert sein. Ein im Substrat 1 durch Dotierung gebildetes p-Gebiet 2 dient als pwell und das darin eingebettete p+-Gebiet als Substratanschluss. Die Bezugsziffern 3, 4 und 5 bezeichnen niedrig dotierte n-LDD-Gebiete (LDD = Lightly Doped Drain = schwach dotierter Drain) jeweils in Source-, Drain- und Zwischengebieten. Seitlich neben den Gates G1 und G2 sind Abstandhalter 7 (sogenannte "Spacer") aus einem geeigneten Dieelektrikum gebildet, die Bezugsziffern 8, 9, 11 bezeichnen n+ dotierte Kontaktgebiete in dem Sourceanschluss S, Drainanschluss D, sowie im Zwischengebiet zwischen den beiden Gates, wobei die Kontaktgebiete 8, 9 und 11 wie in der Darstellung ersichtlich jeweils von Source S und Zwischengebiet durch den Spacer 7 vom betreffenden Gate bzw. Kanal getrennt sind. Durch eine geeignete Einstellung mittels einer Maske ist ein größerer Abstand zwischen Gate G2 bzw. Kanal und Drainanschluss D eingestellt. Die Gateanschlüsse G1 und G2 werden teilweise oder auch vollständig mit n+ Dotierung implantiert. Die p-Wanne 2 endet im Gebiet zwischen dem Gate G2 und dem n+ dotierten Kontaktgebiet 11 des Drainanschlusses D. R bezeichnet einen hochohmigen Widerstand.

Nach Fertigstellung der Isolation (FOX = Feldoxid), der p-Wanne, der Kanalgebiete, der Gates, der LDD-Anschlussgebiete, der Abstandhalter an den Flanken der Gate-Finger, der n+ und p+ Gebiete vermittels an sich bekannter Verfahrensschritte (siehe z.B. Widmann, 'Technologie hochintegrierter Schaltungen', Springer Verlag, 2. Auflage, S.5ff) wird eine selbjustierte Silizidschicht erzeugt. Dazu wird eine TEOS-Si02-Schicht 14 (TEOS = Tetraethylorthosilikat) im LPCVD-Verfahren (LPCVD = low pressure chemical vapor deposition) aufgebracht und mittels einer Lackmaske und Ätzung strukturiert. Dadurch werden die Gebiete für den nachfolgenden Silizierungsprozess definiert. Nach Aufbringen einer dünnen Titan-Schicht vermittels Sputtern (Kathodenstrahlzerstäubung) erfolgt durch schnelles thermisches Aufheizen (RTA = rapid thermal annealing) eine erste Silizierung, d.h. Umwandlung von Titan und Silizium in Titansilizid TiSi 10 an den Stellen, an denen Titan mit Silizium in Kontakt steht. Verbleibende, d.h. nicht umgewandelte Titanreste, werden durch einen anschließenden Ätzprozess entfernt. Vermittels eines weiteren RTA-Prozessschrittes (zweite Silizierung) wird die Titansilizidschicht von einer hochohmigen Phase (C49) in eine nierderohmige Phase (C54) umgewandelt. Für den Silizierungsvorgang sind zwei Schritte erforderlich, da man im ersten Schritt nicht so hohe Temperaturen verwenden darf, wie sie eigentlich benötigt werden, um ein gutes, d.h. niederohmiges Titansilizid zu bekommen. Würde man zu hohe Temperaturen verwenden, besteht die Gefahr, daß das Titan bereits mit dem Silizium des SiO2's reagiert und dies zu leitenden Verbindungen zwischen zu isolierenden Siliziumbereichen führt. Damit wäre der Prozeß nicht mehr selbstjustierend. Im 2. Silizierungsprozeß sind hohe Temperaturen erlaubt, da sich dann kein Titan mehr auf dem Si02 befindet. Es folgt die Abscheidung eines Pre-Metall-Dielektrikums 15 und weitere, bei Standard CMOS-Prozessen übliche Prozessschritte.

Weiterhin kann möglich sein, dass das Regelgate überhaupt nicht siliziert wird, und das Zwischengebiet zwischen den dem Drainanschluss nächstgelegenen Gate und dem hieran unmittelbar benachbarten Gate teilsiliziert wird.

Andererseits kann ebenso eine ausreichende ESD-Festigkeit erreicht werden, wenn man den ersten Elektrodenanschluss bzw. Drainanschluss nur teilweise siliziert und der Abstand zwischen dem silizierten Bereich des Elektrodenanschlusses (Drainanschlusses) und den zugehörenden Kontakten ausreichend groß wählt.

In den Figuren 2, 3 und 4 sind in vergrößerten Schnittdarstellungen nochmals die prinzipiellen Varianten der Gatesilizierung dargestellt, wobei in den Figuren 2, 3, und 4 aus Gründen der besseren Darstellung lediglich die Silizidbereiche 10, Gate-Dielektrikum 12, Gate-Poly 13 und Spacer 7 gezeigt sind.

Das Ausführungsbeispiel nach Figur 2 entspricht dem nach Figur 1 ausführlich dargestellten Beispiel, so dass auf die dortigen Ausführungen verwiesen werden kann. Hier ist der wenigstens eine Steueranschluss G2 nur teilweise siliziert. Durch den verbleibenden, silizierten Teil des Steueranschlusses wird der Steueranschluss G2 insgesamt hinreichend niederohmig. Der nicht silizierte Teil des Steueranschlusses kann eine Ausdehnung von etwa 0,2 µm bis etwa 0,8 µm, insbesondere 0,4 µm bei einer Mindestlänge des Steueranschlusses von etwa 0,6 µm bis etwa 3,0 µm, insbesondere 1,4 µm besitzen.

Bei dem Ausführungsbeispiel nach Figur 3 ist das Zwischengebiet zwischen G1 und G2 teilweise siliziert, Steueranschluß G2 und Drain sind nicht siliziert. Diese Ausführungsform ist jedoch gegenüber dem besonders bevorzugten Ausführungsbeispiel nach Figur 2 verschlechtert, da eine fehlende Silizierung von Gate G2 zu Performanceverlusten führt.

Bei dem Ausführungsbeispiel nach Figur 4 ist der Drainbereich teilsiliziert. Hierbei kann eine ausreichende ESD-Festigkeit nur dann erzielt werden, wenn der Abstand zwischen dem silizierten Bereich des Drainanschlusses und dem Drainkontakt ausreichend groß gewählt wird.

### Bezugszeichenliste

- 1: Halbleitersubstrat
- 2: p-Gebiet
- 3, 4, 5: niedrig dotierte n-LDD-Gebiete
- 6: Polysilizium
- 7: Spacer
- 8, 9, 11: n+ dotierte Kontaktgebiete
- 10: Silizidbereiche
- 12: Gate-Dielektrikum
- 13: Gate-Poly
- 14: TEOS-Si02-Schicht
- G1: Hochfrequenzgate
- G2: Regelgate
- D: Drainanschluss
- S: Sourceanschluss
- VT1, VT2: Kanalbereiche

## Patentansprüche

1. Verfahren zur Herstellung einer Halbleiterschaltungsanordnung mit einem in einem Halbleitersubstrat (1) eines ersten Leitfähigkeitstyps integriert ausgebildeten Schaltungselement_{;} welches wenigstens zwei Steueranschlüsse (G1, G2) sowie einen ersten (D) und zweiten Elektxodenanschluss (S) aufweiset, wobei einer der wenigstens zwei Steueranschlüsse auf seiner der Hauptoberfläche des Halbleitersubstrates abgewandten Seite wenigstens bereichsweise siliziert wird, und wobei die wenigstens zwei Steueranschlüsse (G1, G2) benachbart angeordnet sind, und einer der Steueranschlüsse vollständig und der andere Steueranschluss nicht oder nur bereichsweise siliziert wird.

2. Verfahren nach Anspruch 1, **dadurch gekennzeichnet, dass** der erste Elektrodenanschluss (D) von der silizierung ausgespart wird.

3. Verfahren nach Anspruch 1, **dadurch gekennzeichnet, dass** der erste Elektrodenanschluss (D) allenfalls teilweise siliziert wird.

4. Verfahren nach Anspruch 1 bis 3, **dadurch gekennzeichnet, dass** die Silizierung des wenigstens einen Steueranschlusses und/oder des wenigstens einen Elektrodenanschlusses vermittels einem selbstjustierenden Salizid-Verfahren erfolgt.

5. Verfahren nach Anspruch 1 bis 4, **dadurch gekennzeichnet, dass** die Silizierung durch Titansilizium (TiSi), Wolframsilizium (WSi) oder eine andere vergleichbare, hochtemperaturstabile metallenthaltende Siliziumverbindung durchgeführt wird.

6. Verfahren nach Anspruch 1 bis 5, **dadurch gekennzeichnet, dass** der wenigstens eine Steueranschluss Polysilizium aufweist.

7. Verfahren nach Anspruch 1 bis 6, **dadurch gekennzeichnet, dass** die Halbleiterschaltungsanordnung als diskretes Bauelement mit wenigstens zwei Steueranschltissen ausgebildet wird.

8. Verfahren nach Anspruch 1 bis 7, **dadurch gekennzeichnet, dass** die Halbleiterschaltungsanordnung einen Hochfrequenztranaistor mit wenigstens zwei Steueranschlossen darstellt.

9. Halbleiterachaltungsanordnung mit einem in einem Halbleitersubstrat (1) eines ersten Leitfähigkeitstyps integriert ausgebildeten Schaltungselement, welches wenigstens zwei Steueranschlüsse (G1, G2) sowie einen ersten (D) und zweiten Elektrodenanschluss (S) aufweist, wobei einer der wenigstens zwei Steueranschlüsse auf seiner der Hauptoberfläche des Halbleitersubstrates abgewandten Seite wenigstens bereichsweise siliziert ist, und wobei die wenigstens zwei Steueranschlüsse (G1, G2) benachbart angeordnete sind, und einer der Steueranschlüsse vollständig und der andere steueranschluss nicht oder nur bereichsweise siliziert ist.

10. Halbleiterschaltungsanordnung nach Anspruch 9, **dadurch gekennzeichnet, dass** der erste Elektrodenanschluss (D) von der Silizierung ausgespart ist.

11. Halbleiterschaltungsanordnung nach Anspruch 9, **dadurch gekennzeichnet, dass** der erste Elektrodenanschluss (D) allenfalls teilweise siliziert ist.

12. Halbleiterschaltungsanordnung nach Anspruch 9 bis 11, **da durch gekennzeichnet**, dass die Silizierung des wenigstens einen steueranschlusses und/oder des wenigstens einen Elektrodenanschlusses vermittels eines selbstjustierenden Salizid-Verfahren erfolgt ist.

13. Halbleiterschaltungsanordnung nach Anspruch 9 bis 12, **dadurch gekennzeichnet, dass** die Silizierung durch Titansilizium (TiSi), Molframsilizium (WSi) oder eine andere vergleichbare, hochtemperaturstabile metallenthaltende Siliziumverbindung durchgeführt ist.

14. Halbleiterachaltungsanordnung nach Anspruch 9 bis 13, **dadurch gekennzeichnet, dass** der wenigstens eine Steueranschluss Polysilizium aufweist.

15. Halbleiterachaltungsanordnung nach Anspruch 9 bis 14, **dadurch gekennzeichnet, dass** die Halbleitexschaltungsanordnung als diskretes Bauelement mit wenigstens zwei Steueranschlüssen ausgebildet ist.

16. Halbleiterachaltungsanordnung nach Anspruch 9 bis 15, **dadurch gekennzeichnet, dass** die Halbleiterschaltungsanordnung einen Hochfrequenztransistor mit wenigstens zwei Steueranschlüssen darstellt.

## Claims

1. Method for fabricating a semiconductor circuit arrangement having a circuit element which is formed in an integrated manner in a semiconductor substrate (1) of a first conductivity type and has at least two control terminals (G1, G2) and also a first (D) and second electrode terminal (S), one of the at least two control terminals being siliconized at least in regions on its side remote from the main surface of the semiconductor substrate, and the at least two control terminals (G1, G2) being arranged adjacent, and one of the control terminals is completely siliconized and the other control terminal is not siliconized or is siliconized only in regions.

2. Method according to Claim 1,
**characterized**
**in that** the first electrode terminal (D) is spared from the siliconization.

3. Method according to Claim 1,
**characterized**
**in that** the first electrode terminal (D) is at most partly siliconized.

4. Method according to Claims 1 to 3,
**characterized**
**in that** the siliconization of the at least one control terminal and/or of the at least one electrode terminal is effected by means of a self-aligning salicide method.

5. Method according to Claims 1 to 4,
**characterized**
**in that** the siliconization is carried out by means of titanium silicon (TiSi), tungsten silicon (WSi) or another comparable, metal-containing silicon compound exhibiting high temperature stability.

6. Method according to Claims 1 to 5,
**characterized**
**in that** the at least one control terminal comprises polysilicon.

7. Method according to Claims 1 to 6,
**characterized**
**in that** the semiconductor circuit arrangement is formed as a discrete component with at least two control terminals.

8. Method according to Claims 1 to 7,
**characterized**
**in that** the semiconductor circuit arrangement constitutes a high-frequency transistor with at least two control terminals.

9. Semiconductor circuit arrangement having a circuit element which is formed in an integrated manner in a semiconductor substrate (1) of a first conductivity type and has at least two control terminals (G1, G2) and also a first (D) and second electrode terminal (S),
one of the at least two control terminals being siliconized at least in regions on its side remote from the main surface of the semiconductor substrate, and the at least two control terminals (G1, G2) being arranged adjacent, and one of the control terminals is completely siliconized and the other control terminal is not siliconized or is siliconized only in regions.

10. Semiconductor circuit arrangement according to Claim 9,
**characterized**
**in that** the first electrode terminal (D) is spared from the siliconization.

11. Semiconductor circuit arrangement according to Claim 9,
**characterized**
**in that** the first electrode terminal (D) is at most partly siliconized.

12. Semiconductor circuit arrangement according to Claims 9 to 11,
**characterized**
**in that** the siliconization of the at least one control terminal and/or of the at least one electrode terminal is effected by means of a self-aligning salicide method.

13. The semiconductor circuit arrangement according to Claims 9 to 12,
**characterized**
**in that** the siliconization is carried out by means of titanium silicon (TiSi), tungsten silicon (WSi) or another comparable, metal-containing silicon compound exhibiting high temperature stability.

14. Semiconductor circuit arrangement according to Claims 9 to 13,
**characterized**
**in that** the at least one control terminal comprises polysilicon.

15. Semiconductor circuit arrangement according to Claims 9 to 14,
**characterized**
**in that** the semiconductor circuit arrangement is formed as a discrete component with at least two control terminals.

16. Semiconductor circuit arrangement according to Claims 9 to 15,
**characterized**
**in that** the semiconductor circuit arrangement constitutes a high-frequency transistor with at least two control terminals.

## Revendications

1. Procédé de production d'un circuit à semi-conducteurs comprenant un élément de circuit, intégré dans un substrat (1) semi-conducteur d'un premier type de conductivité et ayant au moins deux bornes (G1, G2) de commande, ainsi qu'une première borne (D) d'électrode et une deuxième borne (S) d'électrode, l'une des au moins deux bornes de commande étant siliciurée au moins par région sur son côté éloigné de la surface principale du substrat semi-conducteur et les au moins deux bornes (G1, G2) de commande étant voisines et l'une des bornes de commande étant siliciurée complètement et l'autre borne de commande ne l'étant pas ou ne l'étant que par régions.

2. Procédé suivant la revendication 1, **caractérisé en ce que** l'on épargne de la siliciuration la première borne (D) d'électrode.

3. Procédé suivant la revendication 1, **caractérisé en qu'**on siliciure tout au plus en partie la première borne (D) d'électrode.

4. Procédé suivant la revendication 1 à 3, **caractérisé en ce qu'**on effectue la siliciuration de la au moins une borne de commande et/ou de la au moins une borne d'électrode au moyen d'un procédé de siliciuration à auto-alignement.

5. Procédé suivant la revendication 1 à 4, **caractérisé en ce qu'**on effectue la siliciuration par du titane silicium (TiSi), du tungstène silicium (WSi) ou par un autre composé du silicium contenant du métal comparable, stable à haute température.

6. Procédé suivant la revendication 1 à 5, **caractérisé en ce que** la au moins une borne de commande comporte du polysilicium.

7. Procédé suivant la revendication 1 à 6, **caractérisé en ce que** le circuit à semi-conducteurs est constitué sous la forme d'un composant discret, ayant au moins deux bornes de commande.

8. Procédé suivant la revendication 1 à 7, **caractérisé en ce que** le circuit à semi-conducteurs constitue un transistor à haute fréquence, ayant au moins deux bornes de commande .

9. Circuit à semi-conducteurs comprenant un élément de circuit intégré dans un substrat (1) semi-conducteur d'un premier type de conductivité et ayant au moins deux bornes (G1, G2) de commande, ainsi qu'une première borne (D) d'électrode et une deuxième borne (S) d'électrode, l'une des au moins deux bornes de commande étant siliciurée au moins par région sur son côté éloigné de la surface principale du substrat semi-conducteur et les au moins deux bornes (G1, G2) de commande étant voisines et l'une des bornes de commande étant siliciurée complètement et l'autre borne de commande ne l'étant pas ou ne l'étant que par régions.

10. Circuit à semi-conducteurs suivant la revendication 9, **caractérisé en ce que** l'on épargne de la siliciuration la première borne (D) d'électrode.

11. Circuit à semi-conducteurs suivant la revendication 9, **caractérisé en qu'**on siliciure tout au plus en partie la première borne (D) d'électrode.

12. Circuit à semi-conducteurs suivant la revendication 9 à 11, **caractérisé en ce que** la siliciuration de la au moins une borne de commande et/ou de la au moins une borne d'électrode est effectuée au moyen d'un procédé de siliciuration à auto-alignement.

13. Circuit à semi-conducteurs suivant la revendication 9 à 12, **caractérisé en ce que** la siliciuration est effectuée par du titane silicium (TiSi), du tungstène silicium (WSi) ou par un autre composé du silicium contenant du métal comparable, stable à haute température.

14. Circuit à semi-conducteurs suivant la revendication 9 à 13, **caractérisé en ce que** la au moins une borne de commande comporte du polysilicium.

15. Circuit à semi-conducteurs suivant la revendication 9 et 14, **caractérisé en ce que** le circuit à semi-conducteurs est constitué sous la forme d'un composant discret, ayant au moins deux bornes de commande.

16. Circuit à semi-conducteurs suivant la revendication 9 à 15 **caractérisé en ce que** le circuit à semi-conducteurs constitue un transistor à haute fréquence, ayant au moins deux bornes de commande.
